# EUROPEAN PATENT APPLICATION

(11) **EP 1 605 595 A1**
(43) Date of publication of application: **14.12.2005**
(21) Application number: 04291438.2
(22) Date of filing: 09.06.2004
(51) Int. Cl.: H03M 7/30

(54) **Method for compressing a short message**

(71) Applicant: Axalto SA, 92120 Montrouge (FR)
(72) Inventor: Sjarif, Krishna, Axalto SA, 92120 Montrouge (FR)

(57) **Abstract**

A method for compressing a message (10), in particular a SMS message to be sent by a GSM network, the message (10) being made of encoded message characters (11), comprising the following compression steps :
a) Counting the number "d" of different encoded characters (12) in the message (10);
b) Calculating the minimum number of bits "b" sufficient to generate "d" different binary short character codes (14);
c) Associating to each of the "d" different characters (12) one, and only one, of the binary short character codes (14), according to the position of the character in a character encoding table (30) providing, for each usable character (32) one, and only one, position (34)
d) Transforming the message (10) into a binary compressed message data (20) by replacing each of said message characters (11) by its corresponding binary short character code (14).

## Description

### BACKGROUND OF THE INVENTION

### 1. Field of the invention

The invention relates to a method to compress a message, in particular a SMS message to be sent by a GSM (Global System for Mobile Communication) network. More generally, it also relates to a method of communication between a sending party and a receiving party, said sending party sending messages compressed according to the invention.

### 2. Description of the Prior Art

It is known to compress messages before sending then and several compression algorithms may be used. Usually, these algorithms need to deal with relative large amount of data to achieve a result with enough effectiveness. Therefore these algorithms are not applicable with short messages.

An SMS (Short Message Service) unit, or "SMS", is a short text limited to 140 bytes, which is sent from one user to another using a GSM network. An SMS can carry a maximum of 140 ASCII characters if each character is coded in one byte. To compress an SMS, an algorithm called "7bit compression algorithm" may be used. According to this algorithm, characters which are usable belong to the so-called "default alphabet" which contains a maximum of 128 characters. These characters may therefore be coded in only seven bits (2⁷=128) instead of eight. Consequently, with the "7 bit compression algorithm", the number of characters that one unit of SMS can carry is increased to 160.

The compression ratio is defined as (C -Cᵢₙᵢ)/Cᵢₙᵢ, where Cᵢₙᵢ is the maximum length of the message without compression and C is the maximum length of the message with compression.

With the "7 bit compression algorithm", the compression ratio is limited for SMS to ~14.28%, i.e. (160-140)/140.

Several other compression algorithms have also been defined inside ETSI GSM 3.42 standard, for example Huffman method, keywords method, punctuation method, etc. However, these algorithms have their own limitations.

Huffman method maps each character of the text to become a bit representation, the length of which being variable according to the frequency of appearance. The higher the frequency of a character is, the shorter the bit representation of this character is. Huffman method is only effective if the plain data is "homogeneous". Also, Huffman method is only effective if the size of data is relatively big. It is not so effective to compress short data such as a SMS.

Keywords method defines a set of most-used words in a certain language and codes these words with determined bytes. Sending and receiving parties maintain a same dictionary table. For example, the word "Please" may be associated with the byte '1010 0100'. The receiving party will decompress '10100100' back to become "Please", using the dictionary table. Thus, keywords method is language specific. It does not compress the words which are not in the dictionary and therefore, it is not appropriate to SMS, the words of which are not limited.

There is therefore a need for a method to compress a message with better compression ratio than the compression ratio of the "7 bit compression algorithm", and which would be efficient for short messages, more particularly for SMS.

The aim of the present invention is to provide for such a method.

### SUMMARY OF THE INVENTION

The aim of the invention is achieved with a method for compressing a message, in particular a SMS message to be sent by a GSM network, said message being made of message characters encoded in long character codes, comprising the following compression steps :
a) Counting the number "d" of different encoded characters in said message;
b) Calculating the minimum number of bits "b" sufficient to generate "d" different binary short character codes;
c) Associating to each of said "d" different encoded characters one, and only one, of said binary short character codes, according to the position of said encoded characters in a character encoding table providing, for each usable character one, and only one, position;
d) Transforming said message into a binary compressed message data by replacing each of said message characters by its corresponding binary short character code.

Since one unit of SMS may not carry more than 160 characters, it is very unlikely that all 128 usable characters will appear in a message. According to the invention, a new reduced set of character codes, hereafter called "binary short character codes", is created. The length of the short character codes is minimal, provided it allows the coding of all of the different characters of the message. The number of characters that it becomes possible to code within the limited number of available bits of a SMS is therefore increased.

As it will be explained in more details, the method of the invention can present compression ratios between about 28% and 50%.

The method according to the invention preferably presents the following features.
- At step c), an encoded character located at a position "p" in said character encoding table is associated with the p^{th} short character code, said short character codes being ordered increasingly or decreasingly.
- The method according to the invention further comprises the step of
   A) Generating a mapping table identifying the respective position of each of said "d" different encoded characters in said character encoding table.
- The method according to the invention further comprises the following steps :
   B) Representing said mapping table as a binary mapping table data;
   C) Concatenating said mapping table data and said compressed message data into a compressed plain data;
- Said mapping table is made of a number "n" of ordered bits, each of said ordered bits being associated with one, and only one, encoded character of said character encoding table.
- Said mapping table is made of "n" ordered bits, a bit of said mapping table, at position "p", being set to 1 if the encoded character corresponding to the position "p" in said character encoding table is present in said message, and set 0 otherwise.

The invention also relates to a method of communication between a sending party and a receiving party, said sending party using a method according to the invention, wherein said character encoding table is made available to both sending and receiving parties. Preferably, the character encoding table is loaded in the phone handsets or the SIM cards.

Preferably, said receiving party operates a decompression of said compressed plain data received from said sending party, said method comprising the following decompression steps :
- Getting said mapping table data from said compressed plain data;
- According to said mapping table data and a character encoding table identical to the character encoding table used by the sending party, calculating the length of said short character codes, and associating an encoded character of said character encoding table to each of the different short character codes of said compressed message data;
- Replacing each of said short character code of said binary message data by its corresponding character.

The invention will now be described in more details.

### BRIEF DESCRIPTION OF THE DRAWINGS

Figure 1 is a diagram schematically representing a method according to the invention.
Figure 2 is a diagram schematically representing a part of the method represented in figure 1.
Figure 3 is a diagram schematically representing a method used to decompress a compressed message sent according to the method represented in figures 1 and 2.
Figure 4 is a diagram schematically representing a compression method according to the invention, in the preferred embodiment.

### DETAILED DESCRIPTION OF THE PREFERRED EMBODIMENTS

The following example is intended to illustrate the invention and to easy its understanding. It is described in a functional way and is not limitative. In particular, the practical way of implementing the method of the invention may be different from the way it is described.

The preferred compression method of the invention follows this illustrative example.

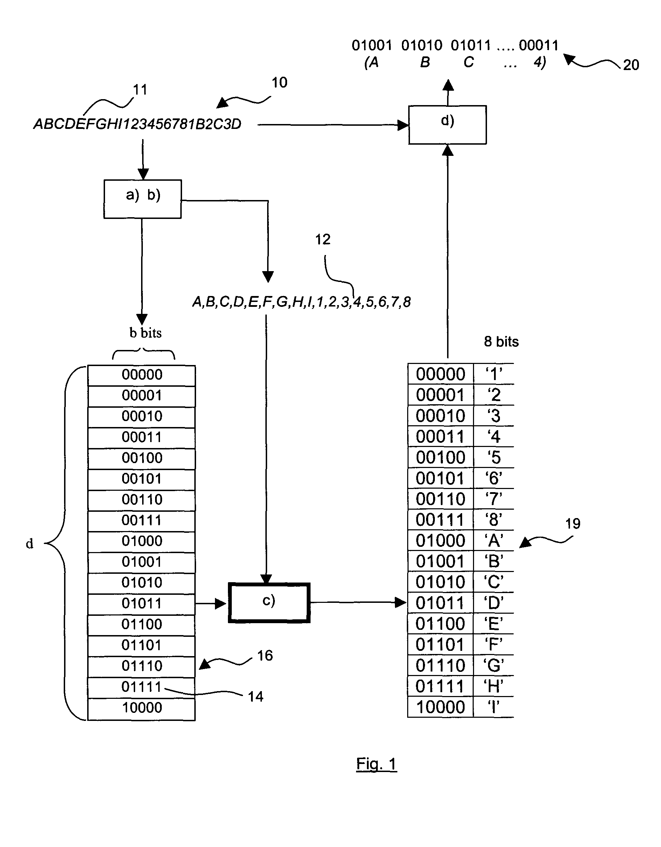

We now refer to figure 1.

A message **10**, containing 23 encoded alpha numerical characters **11** chosen from a list of usable characters, is to be sent by a mobile phone. We assume that the message **10** is an SMS message to be sent by a GSM network, for example:
"ABCDEFGHI123456781 B2C3D4"

The method according to the invention is loaded as a software into a mobile phone handset. Before sending this message, the software first analyses the message **10** to determine the number "d" of different characters **12** it contains (step a)). In the example, "d" is 17 since the message **10** contains the 17 following different characters **12**:
A,B,C,D,E,F,G,H,I,1,2,3,4,5,6,7,8.

The characters **12** are initially encoded with long character codes, preferably on 8 bits, according to the ASCII table.

The software then calculates the minimum number of bits "b" to generate "d" different binary codes, hereafter called "short character codes" **14.** With "b" bits, it is possible to generate up to 2^{b} binary short character codes **14.** In other words, to generate between 2^{b-1}+1 and 2^{b} binary short character codes **14,** b bits are required. 17 is comprised between 2⁴ +1 (=17) and 2⁵ (=32), therefore b = 5 (step b)).

"d" short character codes **14** are then generated and associated to each of the "d" different encoded characters **12** of the message **10**. One short character code **14** is associated to one, and only one, encoded character **12** of the message **10** (step c)). If d <> 2^{b}, the number of possible short character codes **14** is more than the number "d" of different characters **12.** A rule of association "R₁" is then to be used.

According to the preferred rule of association, and as represented in figure 1, the first "d" short character codes **14** are ordered increasingly. They may be stored in a list **16**.

The "d" different encoded characters **12** are ordered according to their position in a character encoding table and, according to their order, are associated to the corresponding ordered short character code **14**.

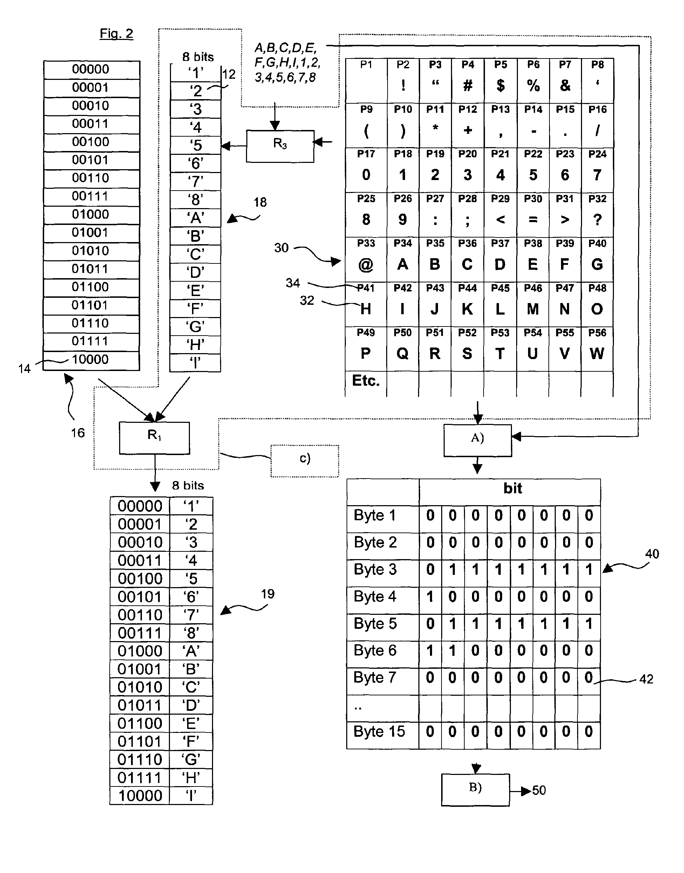

This procedure is now described in more details with reference to figure 2, wherein the block c) represented in the figure 1 is expanded.

An agreement between the sending and receiving parties determines the way of ordering of the short character codes **14.** Preferably, according to a rule R₂, the "d" short character codes **14** are ordered increasingly, starting from 0, each short character code **14** being incremented by 1 from the previous short character code. The short character codes **14** may however be ordered in other ways that by increasing values, for example by decreasing values.

Another agreement between the sending and receiving parties determines the way of ordering the "d" different characters **12**. Preferably, the sending and receiving parties have access to a character encoding table **30** providing, for each usable encoded character **32** (i.e. available to the user to compose the message **10),** a single order number or "position" **34.** In the example, the character encoding table contains 120 characters. Preferably, characters **12** are ordered increasingly according to their position in the character encoding table **30,** according to a rule R₃. However, other rules may be used. For instance, characters 12 may be ordered inversely to their position in the character encoding table 30.

The ordered characters **12** are represented in a list **18.**

The rule of association R₁ preferably associates to the short character code **14** at the position "p" of the list **16** the character **12** at the position "p" of the list **18.** Other rules of association are possible, for example in order to scramble the sent data.

Hereafter, the resulting table is called "conversion table" **19**.

Once each encoded character **12** has been associated with a short character code **14**, the message **10** is transformed into a binary compressed message data **20**, each character **11** being replaced by its corresponding short character code **14** (step d), see figure 1).

In the example, the length of the message is 85 bits (17 characters * 5 bits/character). Without the method of the invention, its length would have been 136 bits (17 characters * 8 bits/character). Hence, the length of the message is reduced and more characters may be sent.

The receiving party needs to interpret the binary compressed message data 20 and to determine what is the length "b" of each short character code as well as the character corresponding to each of the received short character code. According to the invention, additional information is therefore sent with the binary compressed message data **20**. To explain how the method according to the invention operates, we refer to figure 2.

According to the method of the invention, a mapping table **40** identifying the respective position of each of said "d" different characters **12** in said character encoding table **30** is generated (step A)).

The mapping table **40** is preferably made of a number "n" of ordered bits **42**, each of the ordered bits being associated with one, and only one, character **32** of the character encoding table **30**. All usable characters **32** are therefore represented in both the character encoding table **30** and the mapping table 4**0.** Preferably, the position of a bit **42** representing a character **32** in the mapping table **40** is the same as the position of this character in the character encoding table **30**. Hence, if a bit **42** located at position "p" in the mapping table **40** indicates that a character is present in the message **10**, this character may be very simply identified by checking which character is located at the position "p" of the character encoding table **30**.

A bit of the mapping table **40**, at position "p", is preferably set to 1 if the encoded character corresponding to the position "p" in the character encoding table **30** is present in the message 10, and set 0 otherwise.

Since the character encoding table **30** contains 120 characters, the mapping table **40** may be encoded with 15 bytes (15 bytes * 8 bits/bytes = 120). Preferably, the character encoding table **30** should only contain the most frequently necessary characters, so as to minimize the size of the mapping table **40**.

When a character is used in the SMS but is not included inside the character encoding table **30**, this character will be lost and will not be recovered by the receiving party. Preferably, only the characters which are not useful to the user, for example the characters which are not visible to the user, will not be included in the character encoding table **30**.

The updated mapping table **40** may be represented as a binary mapping table data **50** (step B)) which may be concatenated to the compressed message data **20** into a compressed plain data. For example, the mapping table data **50**, the length "L" of which (here 120 bits) is equal to the number of usable characters **32**, may precede the compressed message data **20**.

The compressed plain data contains all the information necessary for the receiving party and is then ready to be sent.

It is now clear that the method according to the invention allows high compression ratio for short messages, in particular for SMS. The compression ratio depends on the degree of homogeneity of the message and on the number of usable characters **32.** In other words, it depends on the number of bits for each short character code **14** and on the length of the mapping table **40**. For instance, if the set off usable characters **32** contains 120 characters or less, the length for the mapping table data **50** will be 120 bits or less. There remains 1000 bits (140*8 - 120) to code for the compressed message data **20.** If the message **10** contains between 17 and 32 different characters, which therefore may be coded on 5 bits, the message **10** may therefore contain up to 200 characters (1000 bits / 5 bits/character). In this example, the compression ratio is therefore 42.86% (= (200-140)/140).

In GSM environment, a user is charged for each SMS sent no matter how much data the SMS carry. The method according to the invention advantageously allows a user to send more information for a same charge.

Advantageously, the method may also be applied to data which are not coded on 8 bits as for the SMS. For example, it may be applied to UCS2 coded data. The length of the mapping table **40** would be adapted consequently.

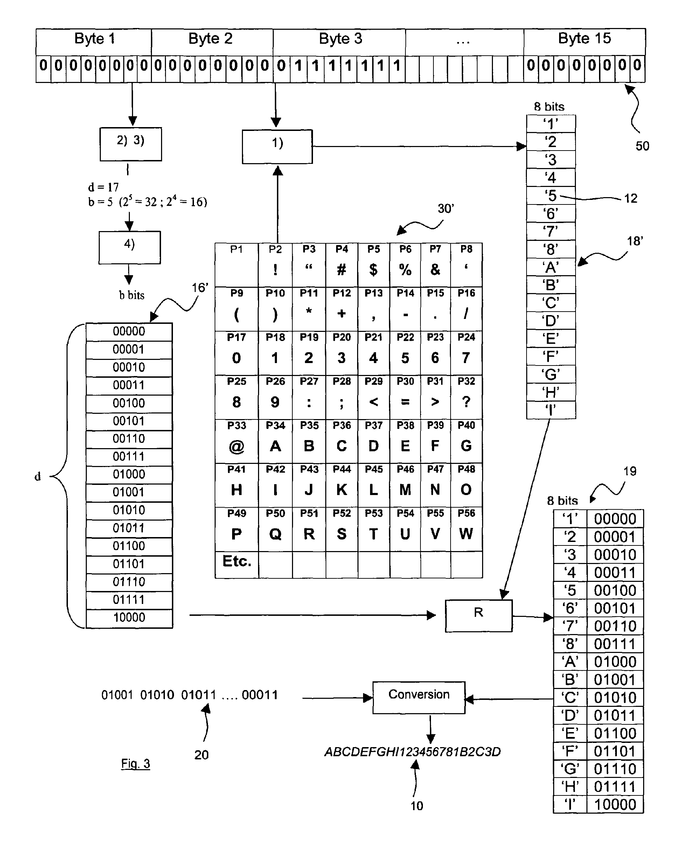

We now refer to figure 3.

When the receiving party receives the compressed plain data, it determines the number "d" of different characters **11** in the original message **10** from the number of bits set to "1" in the first L bits of the compressed plain data. As explained previously (step b)), it infers the number "b" of bits coding for each short character code **14,** and generates and orders "d" short character codes **14,** represented in a list **16'** identical to the list **16** used by the sending party. According to the rule R₂, the short character codes **14** are ordered increasingly, starting from 0.

A character encoding table **30**', identical to the character encoding table **30** is available to the receiving party. The receiving party compares the mapping table data **50** with the character encoding table **30',** using the same rule R₃ as the sending party, so as to identify the long character codes of the "d" different characters **11** of the message **10**, and orders them, for example into a list **18**' identical to the list **18**.

Using the same association rule R₁ as the sending party, each of the different characters **12** of the message **10** is associated with one short character code of the list **16**'. Each of the binary short character code constituting the binary compressed message data **20** is then replaced by its corresponding encoded character **12**, so as to provide the original message **10**. For an SMS, each short character code (5 bit code in the example) will be replaced by an 8 bit code used, according to the ASCII table, to display the corresponding message character **11**.

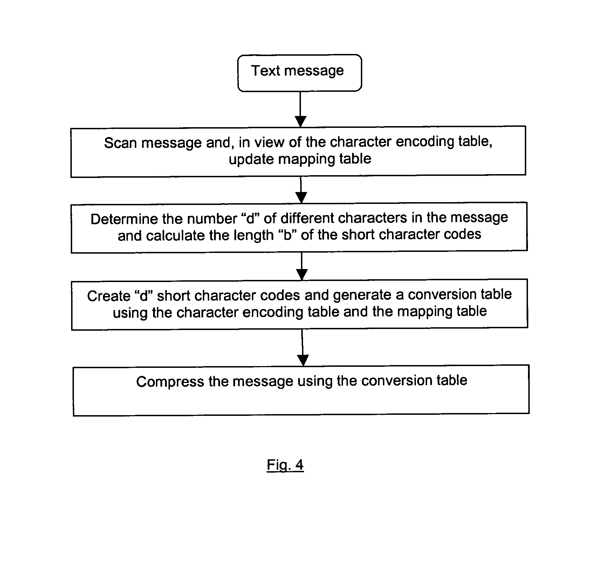

We now describe the preferred compression method of the invention, referring to figure 4.

According to the preferred method of the invention, the message **10**, the characters of which are encoded on 8 bits, is scanned and the mapping table **40**, initially full of "0" is updated, a bit corresponding, in the character encoding table **30**, to a character appearing in the message **10** being set to "1" in the mapping table **40.**

The number "d" of different characters may be calculated as the message **10** is scanned, or calculated at the end of the scanning by summing all the bits of the mapping table **40**. "b" is determined consequently.

A conversion table **19** is then directly generated as follows. The 8 bit code of the character corresponding, in the character encoding table **30,** to the first bit "1" encountered in the mapping table **40** is associated with 0 expressed as a binary short character code (00000). The 8 bit code of the character corresponding to the second bit "1" encountered in the mapping table 40 is associated with 1 expressed as a binary short character code (00001). The 8 bit code of the character corresponding to the third bit "1" encountered in the mapping table **40** is associated with 2 expressed as a binary short character code (00010), etc.

The message **10** is then converted into a compressed message data, each byte coding for the successive characters of the message **10** being changed into the corresponding 5 bit code of the conversion table **19**.

Finally, the compressed message data is concatenated with the mapping table **40**. The resulting compressed plain data is then ready to be sent.

The above examples are not limitative.

## Claims

1. A method for compressing a message (10), in particular a SMS message to be sent by a GSM network, said message (10) being made of message characters (11) encoded in long character codes, comprising the following compression steps :
a) Counting the number "d" of different encoded characters (12) in said message (10);
b) Calculating the minimum number of bits "b" sufficient to generate "d" different binary short character codes (14);
c) Associating to each of said "d" different encoded characters (12) one, and only one, of said binary short character codes (14), according to the position of said encoded characters in a character encoding table (30) providing, for each usable character (32) one, and only one, position (34)
d) Transforming said message (10) into a binary compressed message data (20) by replacing each of said message characters (11) by its corresponding binary short character code (14).

2. A method according to claim 1, wherein, at step c), an encoded character (32) located at a position "p" in said character encoding table (30) is associated with the p^{th} short character code (14), said short character codes being ordered increasingly or decreasingly.

3. A method according to claim 2, further comprising the step of
A) Generating a mapping table (40) identifying the respective position of each of said "d" different encoded characters (12) in said character encoding table (30).

4. A method according to claim 3, further comprising the following steps :
B) Representing said mapping table (40) as a binary mapping table data (50);
C) Concatenating said mapping table data (50) and said compressed message data (20) into a compressed plain data;

5. A method according to claim 3, wherein said mapping table (40) is made of a number "n" of ordered bits (42), each of said ordered bits (42) being associated with one, and only one, encoded character (32) of said character encoding table (30).

6. A method according to claim 3, wherein said mapping table (40) is made of "n" ordered bits (42), a bit of said mapping table (40), at position "p", being set to 1 if the encoded character (32) corresponding to the position "p" in said character encoding table (30) is present in said message (10), and set 0 otherwise.

7. A method of communication between a sending party and a receiving party, said sending party using a compression method according to any preceding claim, wherein said character encoding table (30) is made available to both sending and receiving parties.

8. A method according to claim 7, wherein said receiving party operates a decompression of said compressed plain data received from said sending party, said method comprising the following decompression steps :
- Getting said mapping table data (50) from said compressed plain data;
- According to said mapping table data (50) and a character encoding table (30') identical to the character encoding table (30) used by the sending party, calculating the length of said short character codes (14), and associating an encoded character (12) of said character encoding table (30) to each of the different short character codes of said compressed message data (20);
- Replacing each of said short character code (14) of said binary message data (20) by its corresponding character code (11).
